## Europäisches Patentamt
## European Patent Office
## Office européen des brevets

(11) Veröffentlichungsnummer: **0 476 136 A1**

## EUROPÄISCHE PATENTANMELDUNG
### veröffentlicht nach Art. 158 Abs. 3 EPÜ

(21) Anmeldenummer: **90915983.2**

(22) Anmeldetag: **24.01.90**

(86) Internationale Anmeldenummer: **PCT/SU90/00022**

(87) Internationale Veröffentlichungsnummer: **WO 91/11824 (08.08.91 91/18)**

(51) Int. Cl.⁵: **H01L 25/04**, G11C 17/00

(43) Veröffentlichungstag der Anmeldung: **25.03.92 Patentblatt 92/13**

(84) Benannte Vertragsstaaten: **DE FR GB IT NL SE**

(71) Anmelder: **NAUCHNO-PROIZVODSTVENNY TSENTR ELEKTRONNOI MIKROTEKHNOLOGII AKADEMII NAUK SSR**
**ul. Yaroslavskaya, 13**
**Moscow 129366(SU)**

(72) Erfinder: **SASOV, Jury Dmitrievich**
**ul. Marshala Vasilevskogo, 7-2-184**
**Moscow, 123098(SU)**

(74) Vertreter: **Sparing Röhl Henseler**
**Patentanwälte European Patent Attorneys**
**Rethelstrasse 123**
**W-4000 Düsseldorf 1(DE)**

(54) **DREIDIMENSIONALE ELEKTRONISCHE EINHEIT UND IHRE HERSTELLUNGSMETHODE.**

(57) Das Erfindungswesen besteht darin, dass bei Benutzung der gehäuselosen elektronischen Bauelemente im Baustein diese vorher nach dem Prinzip der Mindestzahl von Anschlusskontakten (5) bei einem Träger (1) gruppiert werden. Bei der Unterbringung der Bauelemente in den im Baustein parallel zueinander angeordneten Trägern (1) werden sie gegeneinander ausgerichtet und vorläufig fixiert. Danach werden die Träger (1) hergestellt, indem die Bauelemente endgültig befestigt werden. Auf die stromleitenden Zonen der Bauelemente wird ausser Kontaktflächen (14) eine Isolierschicht (6) aufgebracht. Die Kontaktflächen (14) der Bauelemente und die Anschlusskontakte (5) der Träger (1) werden von organischen Verschmutzungen und Oxydschichten gereinigt. Auf die Oberflächen der Bauelemente und Träger (1) werden Leiter (7) aufgetragen, die die Träger (1) im Baustein und die Bauelemente mitein-ander und/oder mit den Anschlusskontakten (5) verbinden. Der Baustein ist mit Mitteln zur Wärmeableitung von denen jedes in Form von in den Heizzonen angeordneten wärmeleitenden Rippen (22) und eines Wärmeabfuhrelements (23) ausgeführt ist, und mit Mitteln zur Beschaltung der Träger (1) über die Seitenflächen des Bausteins versehen. Jeder Träger (1) weist mindestens einen auf die Oberfläche des Bausteins gehenden und als dessen Aussenanschluss dienenden Anschluss auf. Die Anschlusskontakte (5) der Träger (1) werden über die Oberfläche des Bausteins elektrisch verbunden, und der Baustein wird in einer hermetisierenden Hülle (21) eingeschlossen.

## Technisches Gebiet

Die vorliegende Erfindung bezieht sich auf die Montage von elektronischen Baugruppen und -geräten unter Anwendung von gekapselten und gehäuselosen elektronischen Bauelementen und betrifft insbesondere einen dreidimensionalen elektronischen Baustein und ein Verfahren für seine Herstellung.

## Zugrundeliegender Stand der Technik

Es ist eine Konstruktion eines dreidimensionalen elektronischen Bausteins (GB,A,2095039A) bekannt, der elektronische Bauelemente enthält, die in Trägern (GB,A,2127217A) untergebracht sind, welche am Umfang mit Anschlusskontakten versehen und parallel zueinander in dem Baustein angeordnet sind, der mit Mitteln zur Wärmeableitung und mit Mitteln zur Beschaltung der Träger über die Seitenflächen des Bausteins ausgestattet ist.

Die Träger sind in Form von Platten aus einem wärmeleitenden Isolierstoff hergestellt, auf deren Oberfläche die Anschlusskontakte liegen. In den Trägern sind gehäuselose elektronische Bauelemente befestigt, die an die Anschlusskontakte der Träger mit Hilfe von räumlichen Leitern geführt sind, wobei die Träger mit den Wänden des Bausteins mittels Gleitkontakten verbunden werden. Jeder Träger ist mit einem Deckel oder durch Verguss einer Kompoundmasse individuell hermetisch abgedichtet. In den Wänden des Bausteins sind Leitungen verlegt, die für eine Parallelschaltung der Träger zueinander sorgen. Als Leitungen können Kontakte benutzt werden, die in den Wänden des Bausteins angeordnet sind. Die Träger liegen mit Abstand, und in den Wänden des Bausteins sind Fenster und Rippen zur Sicherung einer Luftkühlung ausgeführt. Jeder Träger kann bei der Reparatur herausgenommen werden indem eine oder mehrere Wände des Bausteins abgenommen werden. Mit externen Geräten wird der Baustein durch Anschlüsse verbunden, die an den stirnseitigen Trägern angeordnet sind.

Diese Konstruktion, die im ganzen ein fortschrittliches Verfahren zur Anordnung der elektronischen Bauelemente und zur Herstellung von Verbindungen zwischen innen in einem dreidimensionalen Raum realisiert, weist manche technisch-ökonomische Begrenzungen auf:
- die Anordnung von mehreren Bauelementen in einen Träger ist wegen Fehlens von konstruktiven Lösungen erschwert, die auf eine exakte Orientierung der Bauelemente gegeneinander und gegen die Anschlusskontakte des Trägers abzielen, was zur Anwendung einer wenig produktiven manuellen Montage der Bauelemente unweigerlich zwingt;

- die Montage der Bauelemente in den Trägern mittels räumlicher Leiter vermeidet nicht eine eventuelle gegenseitige Berührung der letzteren sowie deren Berührung mit ungeschützten stromleitenden Zonen der Bauelemente bei Montage, Prüfungen und Betrieb des Bausteines;
- in der Konstruktion des Trägers wird die Aufgabe der Anordnung der die Träger im Baustein verbindenden Leiter sehr kompliziert gelöst, was zum Erscheinen einer grossen Menge von Trägern führt, die keine Bauelemente enthalten und lediglich Leiter zur Herstellung von Verbindungen innerhalb des Bausteins aufweisen;
- der Baustein ist konstruktiv in der Weise ausgeführt, dass jeder Träger mit den Wänden des Bausteins durch einen wenig zuverlässigen Gleitkontakt verbunden ist, wobei die längs des Bausteines verlegte gemeinsame Leitung in den Einzelfällen beim Verschwinden des Kontaktes an einer der Berührungsstellen des Trägers und der Wand des Bausteins unterbrochen wird. Darüber hinaus ist es zum Herausnehmen eines ausgefallenen Trägers mit dem Bauelement praktisch notwendig, den gesamten Baustein auszubauen, was die Anwendung der Gleitkontakte bei der Verbindung der Träger mit den Wänden des Bausteins unbegründet macht. Dies beschränkt das Anwendungsgebiet der vorliegenden Konstruktion auf Labormodelle.

Die Herausführung sämtlicher Aussenverbindungen an die Stirnflächen des Bausteins macht die gesamte Konstruktion sehr umfangreich, weil bei einer grossen Anzahl von Aussenanschlüssen bei jedem Träger diese längs des gesamten Bausteins geführt werden müssen, was eine unbegründete Vergrösserung der Abmessungen des Bausteins zur Folge hat.

Die Anwendung der Luftkühlung bedingt die Notwendigkeit, in den Wänden des Bausteins Fenster herzustellen und die Träger im Baustein in einem gewissen Abstand voneinander unterzubringen, was die Packungsdichte der Bauelemente im Baustein stark verringert. Bei der Anordnung der Bausteine nebeneinander wird es keine Belüftung überhaupt geben.

Die Verwendung einer individuellen hermetischen Abdichtung jedes Trägers ist ungerechtfertigt, denn die genannte Konstruktion des Trägers ist nur in der vorgeschlagenen Konstruktion des Bausteins vertretbar.

Das Verfahren zur Herstellung eines dreidimensionalen elektronischen Bausteins gemäss den obengenannten GB-PS umfasst die Herstellung der Träger, die Anordnung der elektronischen Bauelemente im Träger, den elektrischen Anschluss der Bauelemente an die Anschlusskontakte des Trägers, die Parallelanordnung der Träger im Baustein, die Beschaltung der Träger über die Seitenflächen des Bausteins.

Das gemäss GB,A,2127217A angewendete Verfahren zur Herstellung der Träger und zum Einbau der Bauelemente in diese ist aus der Praxis der Montage von AS in Keramikgehäusen (s. z.B. "Tekhnologiya SBIS" unter Redaktion von S. Zi, 1986, Verlag "Mir" (Moskau), H.2,S. 328 bis 384) weit bekannt.

Die Herstellung der keramischen Träger umfasst folgende Operationen:

1. Aus einer aus Keramikpulver, Lösungsmittel und weichmachendem Harz zusammengesetzten Paste werden Dünntafeln gegossen.

2. Die Tafeln werden getrocknet, zerschnitten,mit Rücksicht auf Zwischenverbindungen gelocht.

3. Es werden Leiterbahnen aus Wolfram (nach der Dickschichttechnologie) aufgetragen und die Löcher mit Metall gefüllt.

4. Die Schichten werden umpresst und bei einer Temperatur von +1600°C geglüht.

5. Es werden auf die Wolframschicht Nickel und Gold aufgebracht.

Die Kristalle werden in den Trägern entweder durch Anlöten mit Hartlot oder durch Ankleben mittels eines Klebstoffes aus Polymer von der Rückseite des Kristalls her befestigt.

Der Kristall wird an die Anschlusskontakte des Trägers nach einem der folgenden Verfahren angebracht:

1. Verbindung mittels Gold- oder Aluminiumdraht durch Thermokompressions-, Ultraschall- oder Thermoschallschweissen.

2. Anschluss unter Anwendung eines Bandträgers.

3. Anschluss im Verfahren eines umgedrehten Kristalls.

Die zwei letzteren Verfahren sind mit einer mehrstufigen Züchtung von Säulen oder Kugeln auf den Kontaktflächen des Kristalls mit anschliessender Thermokompressionsschweissung oder Lötung mit einer Gold-Zinn-Eutektik verbunden.

Aus der Beschreibung von GB,A,2127217A folgt, dass hier ein Verbindungsverfahren durch Schweissen mit Drahtanschlüssen vorgesehen ist.

Die Anwendung eines wärmeleitenden Isolierstoffes (Keramik) in der bekannten Konstruktion für die Herstellung der Träger führt zu einem komplizierten und technologisch nicht ungefährlichen technologischen Prozess für ihre Herstellung unter Benutzung von Edelmetallen. In diesem Fall liegen die Kosten des Trägers in der Regel höher als die Kosten des in diesem untergebrachten Bauelements.

Die Befestigung der Bauelemente in den Trägern durch Anlöten oder Ankleben erzeugt im Bauelement beträchtliche Spannungen während des Temperaturzyklus wegen der Unterschiede in den linearen Wärmeausdehnungskoeffizienten der Werkstoffe des Substrats des Bauelements und des Lötmittels (Klebstoffes). In der Konstruktion des keramischen Trägers ist es nicht möglich, Entlastungselemente vorzusehen.

Der Anschluss des Bauelements an die Anschlusskontakte des Trägers durch Schweissen mit Drahtanschlüssen ist stets ein schrittweiser und relativ wenig zuverlässiger Vorgang, was sich auf die Arbeitsintensität und Zuverlässigkeit der elektronischen Geräte negativ auswirkt.

Offenbarung der Erfindung

Der Erfindung liegt die Aufgabe zugrunde, einen dreidimensionalen elektronischen Baustein mit derartiger Anordnung von elektronischen Bauelementen und derartiger Beschaltung der letzteren im dreidimensionalen Raum sowie mit derartiger Organisierung der Wärmeabführung zu schaffen, die es gestatten, die Länge der die Bauelemente miteinander verbindenden Leiter zu verkürzen und eine erleichterte Wärmehaltung des Bausteins zu ermöglichen, sowie ein Verfahren für die Herstellung des elektronischen Bausteins zu schaffen, bei dem sämtliche Operationen gruppenweise ausgeführt werden, was erlaubt, die Reproduzierbarkeit der technischen Kenndaten des Bausteins zu gewährleisten und die Herstellungskosten zu senken.

Die gestellte Aufgabe wird dadurch gelöst, dass in dem dreidimensionalen elektronischen Baustein, der elektronische Bauelemente enthält, die in Trägern untergebracht sind, die am Umfang mit Anschlusskontakten versehen und parallel zueinander in dem Baustein angeordnet sind, der mit Mitteln zur Wärmeableitung und mit Mitteln zur Beschaltung der Träger über die Seitenflächen des Bausteins ausgestattet ist, gemäss der Erfindung bei Benutzung von gehäuselosen elektronischen Bauelementen im Baustein diese gegeneinander orientiert angeordnet sind und in den stromleitenden Zonen ausser Kontaktflächen auch noch eine Isolierschicht aufweisen, darüber hinaus auf der Oberfläche der Träger und der elektronischen Bauelemente Leiter angebracht sind, die die elektronischen Bauelemente untereinander und/oder mit den Anschlusskontakten sowie die Träger im Baustein verbinden, wobei der Baustein auf seiner Oberfläche über Mittel zur festen Verdrahtung der Träger untereinander verfügt, während jeder Träger mindestens einen auf die Oberfläche des Bausteins gehenden und als Aussenanschluss des Bausteins dienenden Anschluss besitzt, wobei das Mittel zur Wärmeableitung in Form von unmittelbar in den Heizzonen angeordneten wärmeleitenden Rippen und eines Wärmeabfuhrelements ausgeführt ist, wobei der Baustein in einer hermetisierenden Hülle eingeschlossen ist.

Bei Benutzung der gehäuselosen elektronischen Bauelemente im Baustein sind sie gegeneinander in den Trägern orientiert befestigt, was es gestattet, eine Identität des Aufbaues einer Apparatur bei deren Serienfertigung zu gewährleisten und im weiteren bei deren Montage gruppenweise zu verfahren, beispielsweise eine Vakuumaufdampfung von Metallschichten durch "freie" Maske zu verwirklichen. Alle stromleitenden Zonen der Bauelemente werden ausser den Kontaktflächen durch eine Isolierschicht geschützt, um einen Kontakt mit den Leitern und anderen Bauelementen bei der Herstellung und dem Betrieb der Apparatur zu verhindern. Die Leiter werden auf die Oberfläche der Bauelemente und Träger aufgebracht, was die Konstruktion kompakter, beständiger gegen mechanische und thermische Einflüsse macht sowie es erlaubt, bei der Montage gruppenweise zu verfahren. Das Entwerfen derartiger Träger wird bei Anwendung mathematischer Verfahren leicht automatisiert, die bei der Verdrahtung herkömmlicher gedruckter Leiterplatten akzeptiert sind.

Der Baustein wird über seine Oberfläche durch einteilige (aber auseinandernehmbare) Mittel, beispielsweise durch Umlöten der Anschlüsse der Träger untereinander, beschaltet. Dies erhöht die Zuverlässigkeit der Verbindungen beträchtlich, während die Anordnung der Kontakte auf der Aussenfläche des Bausteins eine Güteprüfung bei den Verbindungen und gegebenenfalls deren Wiederherstellung zulässt. Jeder Träger weist Anschlüsse auf, die als Aussenanschlüsse des Bausteins auftreten, weshalb alle Aussenanschlüsse längs der Oberfläche des Bausteins liegen, was die Länge der Zwischenverbindungen innerhalb des Bausteins wesentlich verringert und die Konstruktion kompakter macht. Die wärmeleitenden Rippen sind unmittelbar in den Heizzonen angeordnet und weisen einen Wärmekontakt mit dem Wärmeabfuhrelement auf. Dies gestattet es, optimalere Temperaturverhältnisse für die Arbeit jedes Bauelements und der Apparatur im ganzen zu gewährleisten, und führt zu einer beträchtlichen Verminderung ihrer Grösse und Masse. Der gesamte Baustein hat eine einheitliche hermitisierende Hülle, was bei dieser Art der Apparatur als gerechtfertigt gilt, weil dem Einbau in den Baustein eine sorgfältige Kontrolle und ein Training jedes Bauelements als Bestandteil des Trägers vorangehen müssen ebenso wie man den Baustein, bevor er hermetisiert wird, unbedingt eine Zeit lang arbeiten lassen muss.

Es ist zweckmässig, dass die Anschlusskontakte der Träger in Form fester Metallbalken hergestellt sind. Dies vereinfacht die Kontaktierung der Träger im Vorgang der Kontrolle und des Trainings.

Zweckmässig ist, dass mindestens ein Träger samt den daran befestigten elektronischen Bauelementen in Form einer monolithischen Konstruktion hergestellt ist, wobei die elektronischen Bauelemente und der aus polymerem Material hergestellte Träger eine einheitliche Frontfläche besitzen. Dies gestattet es, die Menge der Träger zur gleichen Zeit gruppenweise herzustellen.

Um die Bauelemente von den bei einem Arbeitstemperaturgefälle entstehenden mechanischen Beanspruchungen erheblich zu entlasten, ist es notwendig, dass bei den Trägern Nuten und Fenster in Spannungskonzentrationszonen ausgeführt sind, die an den Stirn- und Rückflächen der elektronischen Bauelemente anliegen. Dies erlaubt es, den Temperaturbereich für die Anwendung der Konstruktion zu vergrössern, und macht sie zuverlässiger.

Es ist sinnvoll, dass die Isolierschicht auf den Trägern in Form einer teilweisen Auftragung auf die Frontseite der elektronischen Bauelemente aus polymerem Material des Trägers erzeugt ist. Dies gibt die Möglichkeit, zugleich mit der Herstellung des Trägers die stromleitenden Zonen der Bauelemente zu schützen, was die Technologie seiner Herstellung unter den Bedingungen einer Kleinserien- und Einzelfertigung vereinfacht.

Die Isolierschicht auf den Trägern kann in Form einer dünnen Dielektrikumschicht erzeugt sein, die auf die Oberflächen der elektronischen Bauelemente und der Träger aufgebracht ist. Dies ist bei einer dichten Anordnung der Kontaktflächen auf den elektronischen Bauelementen und bei der Auftragung der Leiter in Verfahren, bei denen eine hohe Ebenheit der Oberfläche des Erzeugnisses notwendig ist, sowie bei einer Großserien- und Massenfertigung anwendbar.

Es wird bevorzugt, dass mindestens ein Träger in Form einer am Aussenrahmen des Trägers befestigten flexiblen Leiterplatte mit einer die Aussenanschlusskontakte auf der Front-, Stirn- und Rückfläche des Trägers bildenden Verdrahtung hergestellt ist. Die Platte ist um den Aussenrahmen gebogen und bildet die Anschlusskontakte des Trägers. Diese Ausführungsform der Konstruktion ist bei der Lieferung der Bauelemente auf einem flexiblen Träger weit anwendbar.

Um die Anwendungsmöglichkeiten von vereinheitlichten Trägern aus einer Konstruktion auf die andere auszudehnen, ist es erwünscht, dass mindestens einer der Träger aus Einzelteilen besteht, die elektrisch und mechanisch über auf deren Oberflächen liegende Kontakte verbunden sind.

Bei Anwendung einer Vielzahl von Bauelementen verschiedener Grösse ist es erwünscht, dass die Träger mit Platten versehen sind, die aus einem Werkstoff mit einer hohen Wärmeleitfähigkeit hergestellt und in denen die elektronischen Bauelemente untergebracht sind. Dies erleichtert die Temperaturführung bei der Arbeit der elektronischen Bauelemente und erhöht die Zuverlässigkeit der Geräte.

Die gestellte Aufgabe wird auch dadurch gelöst, dass der dreidimensionale elektronische Baustein, der elektronische Bauelemente enthält, die in Trägern untergebracht sind, welche am Umfang mit Anschlusskontakten versehen und parallel zueinander in dem Baustein angeordnet sind, der mit Mitteln zur Wärmeableitung und mit Mitteln zur Beschaltung der Träger über die Seitenflächen des Bausteins ausgestattet ist, gemäss der Erfindung mindestens ein in einem als Träger dienenden Gehäuse eingeschlossenes elektronisches Bauelement aufweist, wobei auf der Oberfläche des Bausteins Mittel zur festen Verdrahtung der Anschlüsse der Träger untereinander angebracht sind, während jedes gekapselte elektronische Bauelement mindestens einen an die Oberfläche des Bausteins gehenden und als dessen Aussenanschluss dienenden Anschluss besitzt, wobei das Mittel zur Wärmeableitung in Form von unmittelbar in den Heizzonen angeordneten Wärmeleitenden Rippen und eines Wärmeabfuhrelements ausgeführt ist, wobei der Baustein in einer hermetisierenden Hülle eingeschlossen ist.

Die Anwendung von gekapselten Bauelementen, beispielsweise von integrierten Mikroschaltungen mit Planaranschlüssen, in der Konstruktion des Bausteins macht diese Konstruktion universell.

Die gestellte Aufgabe wird auch dadurch gelöst, dass der dreidimensionale elektronische Baustein, der elektronische Bauelemente enthält, die in Trägern untergebracht sind, welche am Umfang mit Anschlusskontakten versehen und parallel zueinander in dem Baustein angeordnet sind, der mit Mitteln zur Wärmeableitung und mit Mitteln zur Beschaltung der Träger über die Seitenflächen des Bausteine ausgestattet ist, gemäss der Erfindung gehäuselose elektronische Bauelemente und mindestens ein in einem als Träger dienenden Gehäuse eingeschlossenes elektronisches Bauelement aufweist, wobei die gehäuselosen elektronischen Bauelemente in den Trägern gegeneinander orientiert angeordnet sind und in den stromleitenden Zonen ausser Kontaktflächen auch noch eine Isolierschicht besitzen, wobei auf der Oberfläche der Träger und der gehäuselosen elektronischen Bauelemente Leiter angebracht sind, die die elektronischen Bauelemente untereinander und/oder mit den Anschlusskontakten der Träger sowie die Träger im Baustein verbinden, wobei der Baustein auf seiner Oberfläche über Mittel zur festen Verdrahtung der Träger und der gekapselten elektronischen Bauelemente untereinander verfügt, während jeder Träger und jedes gekapselte elektronische Bauelement mindestens einen auf die Oberfläche des Bausteins gehenden und als dessen Aussenanschluss dienenden Anschluss aufweist, wobei das Mittel zur Wämeableitung in Form von unmittelbar in den Heizzonen angeordneten wärmeleitenden Rippen und eines Wärmeabfuhrelements ausgeführt ist, wobei der Baustein in einer hermetisierenden Hülle eingeschlossen ist.

Um eine wahlfreie Verbindung der Anschlusskontakte der Träger auf der Oberfläche des Bausteins zu gewährleisten, ist es notwendig, dass das Mittel zur festen Verdrahtung der Träger mindestens eine gedruckte Leiterplatte enthält, die mit den Anschlusskontakten der Träger, welche auf den Stirnflächen der letzteren angebracht sind, und/oder mit den Anschlüssen der gekapselten elektronischen Bauelemente verbunden ist. Dies erlaubt es, die Packungsdichte zu erhöhen.

Um die Zuverlässigkeit der Konstruktion des Bausteins zu erhöhen, ist es vorzuziehen, dass das Mittel zur festen Verdrahtung der Träger in Form von Leitern ausgeführt ist, die unmittelbar auf die Oberfläche des Bausteins unter teilweiser Überdeckung der Anschlusskontakte der Träger und/oder der Anschlüsse der gekapselten elektronischen Bauelemente aufgebracht sind.

Um die Zuverlässigkeit weiter zu erhöhen, ist es notwendig, dass das Mittel zur festen Verdrahtung der Träger in Form von mindestens einer gedruckten Leiterplatte und von gegeneinander durch eine Isolierschicht getrennten Leitern ausgebildet ist, wobei die Leiter auf der Oberfläche des Bausteins liegen sollen.

Um die Entfernung eines ausgefallenen Trägers durch Durchschneiden von Leitern unter anschliessendem Entfernen und Austausch des Trägers zu erleichtern, ist es nötig, dass das Mittel zur festen Verdrahtung der Träger in Form einzelner, über der Oberfläche des Bausteins angeordneter räumlicher Leiter ausgeführt ist.

Es ist zweckmässig, dass das elektronische Bauelement wenigstens eine Fläche aufweist, die einen Wärmekontakt mit den Mitteln zur Wärmeableitung hat. Auf solche Weise wird für den Wärmekontakt eines elektronischen Bauelements mit den Mitteln zur Wärmeableitung über dessen beliebige Fläche einschliesslich der Stirnflächen gesorgt. Dies erleichtert die Wärmeführung bei der Arbeit des Bauelements und des Bausteins im ganzen beträchtlich und erhöht folglich die Zuverlässigkeit der Konstruktion.

Um eine elektrische Abschaltung einzelner Träger zu ermöglichen oder zusätzliche Verbindungen selbst nach der endgültigen hermetischen Abdichtung des Bausteins, darunter auch während des Betriebes, herzustellen, ist es notwendig, dass in der hermetisierenden Hülle des Bausteins Fenster zur Ermöglichung einer Korrektur der Verbindungsschaltung der elektronischen Bauelemente ausgeführt sind.

Die gestellte Aufgabe wird auch dadurch gelöst, dass im Verfahren zur Herstellung eines dreidimensionalen elektronischen Bausteins, das die Anordnung der elektronischen Bauelemente im Träger, einen elektrischen Anschluss der elektronischen Bauelemente an die Anschlusskontakte des Trägers, eine Parallelanordnung der Träger im Baustein, die Beschaltung der Träger über die Seitenflächen des Bausteins umfasst, gemäss der Erfindung bei Benutzung von gehäuselosen elektronischen Bauelementen im Baustein diese vorher nach dem Prinzip einer mindestmöglichen Anzahl der Anschlusskontakte beim Träger gruppiert, die elektronischen Bauelemente gegeneinander ausgerichtet und vorläufig fixiert, die Träger mit einer endgültigen Befestigung der elektronischen Bauelemente in ihnen gefertigt, die ungeschützten stromleitenden Zonen der elektronischen Bauelemente ausser den Kontaktflächen elektrisch isoliert, die Kontaktflächen der elektronischen Bauelemente und die Anschlusskontakte der Träger von organischen Verschmutzungen und Oxydschichten gereinigt, auf die Oberflächen der elektronischen Bauelemente und der Träger Leiter aufgebracht, die Anschlusskontakte der Träger auf der Oberfläche des Bausteins elektrisch beschaltet werden, der zusammengebaute Baustein hermetisiert wird.

Die gestellte Aufgabe wird auch dadurch gelöst, dass im Verfahren zur Herstellung eines dreidimensionalen elektronischen Bausteins, das die Anordnung der elektronischen Bauelemente im Träger, einen elektrischen Anschluss der elektronischen Bauelemente an die Anschlusskontakte des Trägers, eine Parallelanordnung der Träger im Baustein, die Beschaltung der Träger über die Seitenflächen des Bausteins umfasst, gemäss der Erfindung bei Benutzung von gehäuselosen elektronischen Bauelementen im Baustein diese vorher nach dem Prinzip einer mindestmöglichen Anzahl der Anschlusskontakte beim Träger gruppiert, die ungeschützten stromleitenden Zonen der elektronischen Bauelemente ausser den Kontaktflächen isoliert, die elektronischen Bauelemente gegeneinander ausgerichtet und vorläufig fixiert, die Träger mit einer endgültigen Befestigung der elektronischen Bauelemente in ihnen gefertigt, die Kontaktflächen der elektronischen Bauelemente und die Anschlusskontakte der Träger von organischen Verschmutzungen und Oxydschichten gereinigt, auf die Oberflächen der elektronischen Bauelemente und der Träger Leiter aufgebracht, die Anschlusskontakte der Träger auf der Oberfläche des Bausteins elektrisch beschaltet werden, der zusammengebaute Baustein hermetisiert wird.

Die vorherige Gruppierung der elektronischen Bauelemente nach dem Prinzip einer mindestmöglichen Kontaktzahl beim Träger gewährleistet die Anordnung mehrerer Bauelemente mit einer Höchstzahl von Verbindungen zwischen den Bauelementen im Träger. Die Orientierung der Bauelemente und deren vorläufige Fixierung gestatten es, auf dem Wege der Durchführung einer Kontrolle die bei der Anordnung der Bauelemente zugelassenen Fehler zu verbessern. Die Herstellung der Träger mit der endgültigen Befestigung der Bauelemente unter Anwendung von polymeren Materialien durch Giessen oder Pressen sichert einen niedrigen Arbeitsaufwand bei der Herstellung des Trägers. Die Isolierung der ungeschützten stromleitenden Zonen bei den Bauelementen, die gruppenweise entweder zugleich mit der Fertigung des Trägers oder durch Auftragung von Isolationsschichten durchgeführt wird, zielt auf eine Zuverlässigkeitserhöhung beim Erzeugnis ab. Die Reinigung der Kontaktflächen der Bauelemente von den organischen Verschmutzungen und den Oxydschichten gestattet es, die Verschmutzungen im Bereich der Verbindung des Leiters mit der Kontaktfläche des Bauelements zu vermeiden, die zu einer Korrosion führen, sowie einen sicheren elektrischen Kontakt an der Verbindungsstelle zu gewährleisten. Die elektrische Verbindung der Anschlusskontakte der Träger auf der Oberfläche des Bausteins erlaubt es, mit hochproduktiven Verfahren (beispielsweise durch Vakuumaufdampfung von Leitern durch "freie" Masken) eine grosse Menge der Leiter gleichzeitig aufzutragen, wobei die geringe Dicke der Leiter den Träger kompakt macht. Dies hat eine Verringerung der Grösse und Masse des Trägers sowie der Arbeitsintensität bei seiner Herstellung zur Folge. Die Hermetisierung des Bausteins mit beispielsweise einer Niedertemperatur-Vergussmasse sichert ein normales Funktionieren des Bausteins bei verschiedenen klimatischen Bedingungen.

Die Durchführung der Operation der Isolierung der ungeschützten stromleitenden Zonen der elektronischen Bauelemente, bevor sie ausgerichtet und vorläufig fixiert worden sind, erlaubt es, die Operation der Isolierung nach oder während der Herstellung des Trägers auszuschliessen.

Es ist sinnvoll, dass die gehäuselosen elektronischen Bauelemente untereinander nach deren Kontaktflächen in optischen Verfahren ausgerichtet sind.

In den anderen Fällen ist es zweckmässig, dass die gehäuselosen elektronischen Bauelemente untereinander nach ihrer Kontur orientiert sind.

Die Orientierung der Bauelemente nach der Kontur erfolgt im Falle der Sicherung der erforderlichen Genauigkeit und Reproduzierbarkeit der Abmessungen der Bauelemente. Diese Variante der Operation ist hochproduktiv, anwendbar aber nur auf Bauelemente mit grossen Kontaktflächen (des Typs von ohmschen Widerständen oder Kondensatoren).

Zweckmässig ist, dass die elektronischen Bauelemente vorläufig durch Ankleben mit der Frontseite an einer Klebstoffschicht, die auf einen flexiblen polymeren Film aufgebracht ist, fixiert werden.

Es ist zweckmässig, dass auf die Frontseite der elektronischen Bauelemente eine Klebstoffschicht aufgetragen und die elektronischen Bauelemente vorläufig durch deren Ankleben mit der Frontseite an einem flexiblen polymeren Film fixiert werden.

Günstig ist es auch, dass die elektronischen Bauelemente durch Anordnung in den Fenstern einer Schablone erst fixiert und dann mit den Kontaktflächen an einen auf eine flache Platte aufgebrachten elastischen Überzug angedrückt werden, bis sie als Bestandteil des Trägers befestigt worden sind.

Sinnvoll ist es auch, dass die elektronischen Bauelemente vorläufig durch Vakuumandruck der Kontaktflächen an einen auf eine flache Platte aufgebrachten elastischen Überzug fixiert werden, bis sie als Bestandteil des Trägers befestigt worden sind.

Es erwies sich am vorteilhaftesten, gleichzeitig mit den elektronischen Bauelementen auch einen Metallrahmen als Anschluss durch Ankleben vorläufig zu fixieren.

Es ist nötig, dass die Klebstoffschicht nach dem Ankleben der elektronischen Bauelemente und des als Anschluss fungierenden Metallrahmens von den offenen Teilen des flexiblen polymeren Filmes entfernt wird.

Die vorläufige Fixierung der elektronischen Bauelemente und gegebenenfalls des als Anschluss fungierenden Metallrahmens durch deren Ankleben mit der Frontseite am flexiblen polymeren Film unter anschliessender Entfernung des Klebstoffes von den offenliegenden Teilen des Filmes und von den Frontflächen der elektronischen Bauelemente nach der erfolgten Abnahme des Filmes wird für Bauelemente mit kleinen Kontaktflächen (vom Typ integrierter Schaltkreise) verwendet, um deren Fixierung mit einer höheren Genauigkeit zu gewährleisten. Die Anordnung der elektronischen Bauelemente in den Fenstern der Schablone oder mit Hilfe des Vakuumandrucks unter anschliessendem mechanischen Andrücken ihrer Kontaktflächen an die flache elastische Grundplatte, bis sie als Bestandteil des Trägers befestigt worden sind, gestattet es, dem Ankleben der Bauelemente mit anschliessender Entfernung der Klebstoffschicht vorzubeugen, und ist für Bauelemente mit einer guten Reproduzierbarkeit der Abmessungen und der Anordnung der Kontaktflächen anwendbar.

Zur Entlastung der elektronischen Bauelemente von den mechanischen Beanspruchungen bei der Durchführung des Wärmezyklus ist die endgültige Befestigung der elektronischen Bauelemente zweckmässigerweise durch ein polymeres Material mit einem an den Werkstoff ihres Substrats angepassten linearen Wärmeausdehnungskoeffizienten vorzunehmen. Dies gestattet es, den Anwendungsbereich der in Rede stehenden Konstruktion des dreidimensionalen elektronischen Bausteins zu erweitern.

Es ist notwendig, dass der flexible polymere Film nach der endgültigen Befestigung der elektronischen Bauelemente entfernt und die Frontseite der elektronischen Bauelemente und des als Anschluss fungierenden Metallrahmens von der Klebstoffschicht gereinigt wird.

Um ein Schliessen der Leiter mit dem Substratmaterial der elektronischen Bauelemente zwecks Zuverlässigkeitserhöhung zu verhindern, ist es notwendig, dass die ungeschützten stromleitenden Zonen der elektronischen Bauelemente durch eine lokale Auftragung von Isolierschichten ohne Poren und Durchgangslöcher isoliert werden.

Es ist zweckmässig, dass die Auftragung der Leiter auf die Kontaktflächen der elektronischen Bauelemente und den Träger unter gleichzeitiger Formierung seiner Anschlusskontakte erfolgt. Die gleichzeitige Auftragung der Anschlusskontakte samt den Leitern ist beispielsweise bei einer Vakuumaufdampfung der Leiter möglich. Dies setzt den Arbeitsaufwand bei der Herstellung der Träger durch Ausschluss des Kontaktrahmens aus ihrer Konstruktion beträchtlich herab.

Es ist zweckdienlich, dass die in Form fester Metallbalken ausgebildeten Anschlusskontakte der Träger in der Weise abgebogen werden, dass der elektrische Kontakt zwischen den Anschlüssen der benachbarten Träger unter deren anschliessender Umlötung bei der Montage des Bausteins gesichert wird. Dies führt zur Senkung des Arbeitsaufwandes beim Auswechseln der Träger bei ihrer Anwendung in der Konstruktion des Bausteins mit einer regelmässigen Verdrahtung.

Es ist notwendig, dass die die Anschlusskontakte auf der Front- und Rückseite aufweisenden Träger bei deren Anordnung im Baustein mit Abstand angeordnet und unter Benutzung eines Kapillareffekts umgelötet werden, wodurch eine mechanische und elektrische Verbindung zustande kommt. Bei derartiger Anordnung der Träger ist die erfindungsgemässe Konstruktion des elektronischen Bausteins leicht auszubauen, bevor er ganz hermetisiert worden ist.

Falls ein niedriger Widerstand der Leiter erhalten werden muss, ist es zweckmässig, dass nach der Aufbringung der Leiter auf die Träger sie sich durch einen elektrisch leitenden Werkstoff aufwachsen lassen, bis die erforderlichen elektrotechnischen Eigenschaften erreicht worden sind.

Die vorliegende Erfindung gestattet es:

- die Masse und den Umfang der elektronischen Geräte durch Minimierung der Abmessungen der Träger, deren rationelle Anordnung im Baustein, durch Benutzung von Mehrelementträgern, durch Anbringung der Anschlusskontakte längs der gesamten Oberfläche des Bausteins wesentlich zu verringern;
- die Zuverlässigkeit durch Austausch wenig zuverlässiger Verbindungen vom Typ eines Gleitkontaktes gegen hochzuverlässige vom Typ abgeschiedener Metallschichten, durch Reduzierung der Kontaktzahl, durch Einführung einer effektiven Wärmeableitung zu erhöhen;
- das Frequenzverhalten durch Verkürzung der Längen von die elektronischen Bauelemente im Baustein verbindenden Leitern zu verbessern;
- die Verwendung kostspieliger und wenig zuverlässiger mehrlagiger Leiterplatten in der Apparatur zu vermeiden, denn über mehr als 90% sämtlicher Verbindungen zwischen den Bauelementen werden im Baustein realisiert;
- die Herstellungskosten der Apparatur durch Anwendung hochproduktiver Gruppenoperationen zu senken.

Kurze Beschreibung der Zeichnungen

Die vorliegende Erfindung soll nachstehend an konkreten Ausführungsbeispielen anhand von beigefügten Zeichnungen näher erläutert werden. Es zeigt:

Fig. 1 eine erfindungsgemässe Ausführungsform der Konstruktion eines Trägers;

Fig. 2 eine erfindungsgemässe Konstruktion eines Trägers mit Nuten zur Entlastung eines Bauelements;

Fig. 3 eine erfindungsgemässe Ausführungsform eines Trägers unter Benutzung einer flexiblen Leiterplatte;

Fig. 4 eine erfindungsgemässe Konstruktion eines zusammengesetzten Trägers;

Fig. 5 die Gesamtansicht eines erfindungsgemässen dreidimensionalen elektronischen Bausteins;

Fig. 6 die Verbindung von erfindungsgemässen Trägern durch auf die Oberfläche des Bausteins aufgetragene Leiter;

Fig. 7 die Verbindung von erfindungsgemässen Trägern durch räumliche Leiter;

Fig. 8 die Verbindung von erfindungsgemässen Trägern durch abgebogene Anschlüsse;

Fig. 9 die Verbindung von erfindungsgemässen Trägern durch Lötung;

Fig. 10 einen Querschnitt durch einen erfindungsgemässen dreidimensionalen elektronischen Baustein mit einer über eine Stirnfläche eines elektronischen Bau - steins erfolgenden Wärmeabführung;

Fig. 11 einen Längsschnitt durch einen erfindungsgemässen dreidimensionalen elektronischen Baustein mit Wärmeableitern;

Fig. 12 die Aussenansicht eines erfindungsgemässen dreidimensionalen elektronischen Bausteins mit einem Fenster in einer hermetisierenden Hülle;

Fig. 13 ein erfindungsgemässes Verfahren zur Ausrichtung eines elektronischen Bauelements nach Kontaktflächen;

Fig. 14 ein erfindungsgemässes Verfahren zur Ausrichtung eines elektronischen Bauelements nach der Kontur;

Fig. 15 ein erfindungsgemässes Verfahren zur vorherigen Fixierung eines elektronischen Bauelements durch einen Vakuumandruck;

Fig. 16 ein erfindungsgemässes Verfahren zur Befestigung eines elektronischen Bauelements durch ein polymeres Material;

Fig. 17 ein erfindungsgemässes Verfahren zur Auftragung einer Isolierschicht auf eine Stossnaht eines elektronischen Bauelements und eines Trägers;

Fig. 18 ein erfindungsgemässes Verfahren zur Auftragung von Leitern und Anschlusskontakten auf einen Träger.

Bestes Ausführungsbeispiel der Erfindung

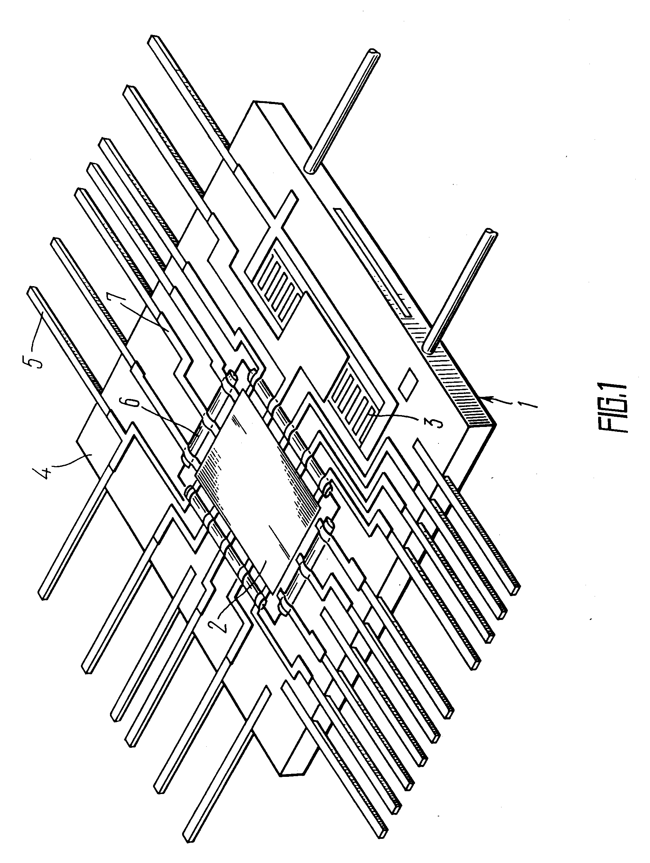

Der erfindungsgemässe dreidimensionale elektronische Baustein enthält Träger 1 (Fig. 1), in denen elektronische Bauelemente, beispielsweise ein Kristall 2 eines integrierten Schaltkreises, gehäuselose Widerstände 3, die durch ein polymeres Material 4 samt festen Anschlusskontakten 5 umpresst sind. Die stromleitenden Zonen des Kristalls 2 sind durch eine Isolierschicht 6 in Form von Auftragungen des polymeren Materials 4 geschützt. Auf die Oberflächen des Kristalls 2, der Widerstände 3 und des Trägers 1 sind Leiter 7 aufgebracht, die die Bauelemente miteinander und mit den Anschlusskontakten 5 zusammenschalten sowie zur Verbindung der Träger 1 miteinander nach deren Einbau in den Baustein dienen.

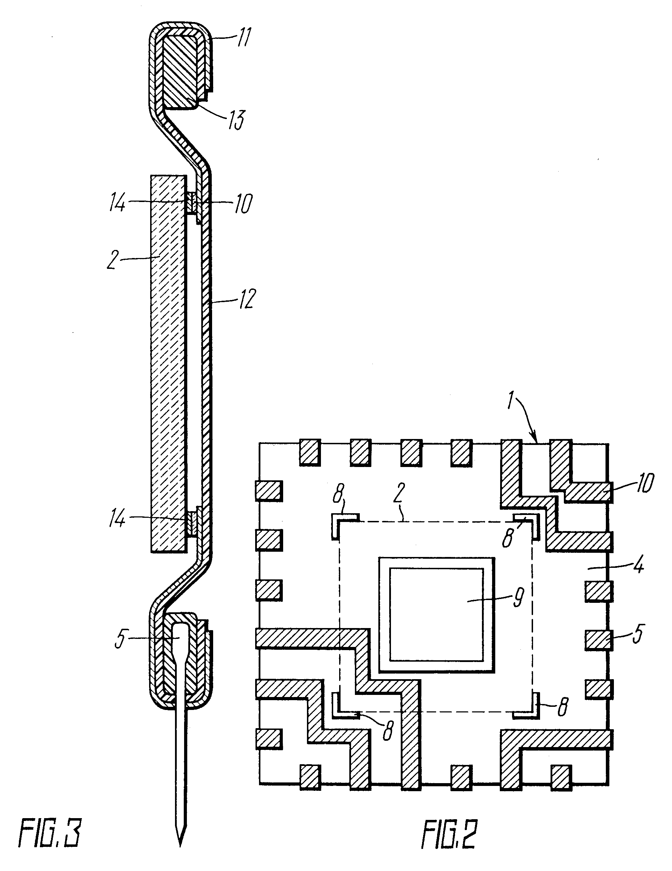

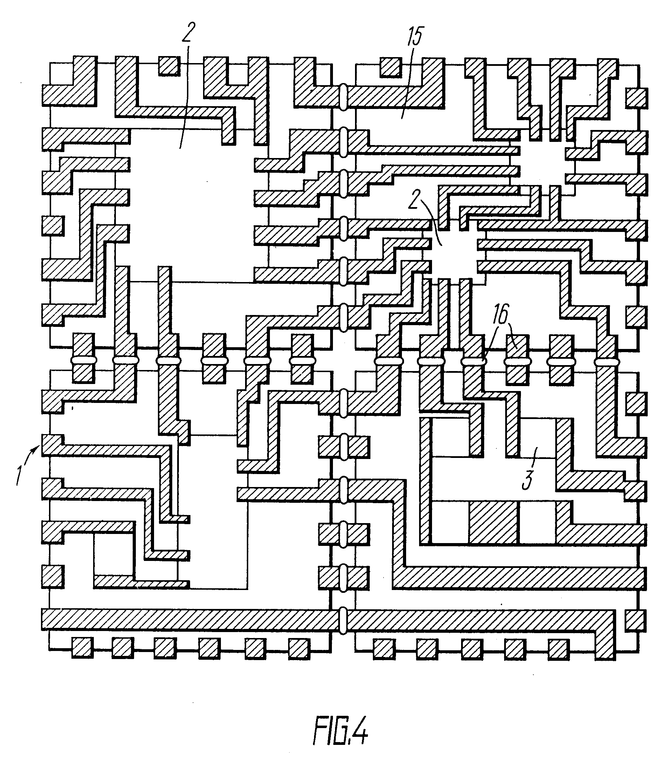

Zur mechanischen Entlastung der elektronischen Bauelemente von Spannungen, die durch einen Unterschied von linearen Wärmeausdehnungskoeffizienten des Substrats des Kristalls 2 und des Materials 4 des Trägers 1 bedingt sind, sind in der Zone der Ecken des Kristalls 2 (Fig. 2) Nuten 8 und auf der Rückseite ein Fenster 9 ausgeführt. In Fig. 2 ist die Schraffierung konventionell angedeutet. In dieser Ausführungsform des Trägers 1 sind die Anschlusskontakte 5 gleichzeitig mit den Leitern 7 ausgeführt, wodurch Aussenanschlüsse l0 gebildet werden, die auf die Front-, Stirn- und Rückseite des Trägers 1 aufgebracht sind. Werden im Baustein die Kristalle 2 (Fig. 3) des integrierten Schaltkreises oder andere elektronische Bauelemente ausgenutzt, die an eine Verdrahtung 11 geschaltet sind, so ist der Träger 1 in Form einer flexiblen Leiterplatte 12 ausgeführt, die an einem Aussenrahmen 13 mit den Anschlusskontakten 5 befestigt ist. In diesem Fall kann eine starre Befestigung der elektronischen Bauelemente beim Träger 1 entfallen: der Kristall 2 ist mit der Verdrahtung 11 mittels Kontaktflächen 14 elektrisch verbunden.

Einer der Träger 1 (Fig. 4) kann aus Einzelteilen 15 bestehen, die miteinander über auf ihren Oberflächen befindliche Kontakte 16 beispielsweise mit Hilfe eines Lötmittels verbunden sind. Die Schraffierung ist in Fig. 4 konventionell angedeutet.

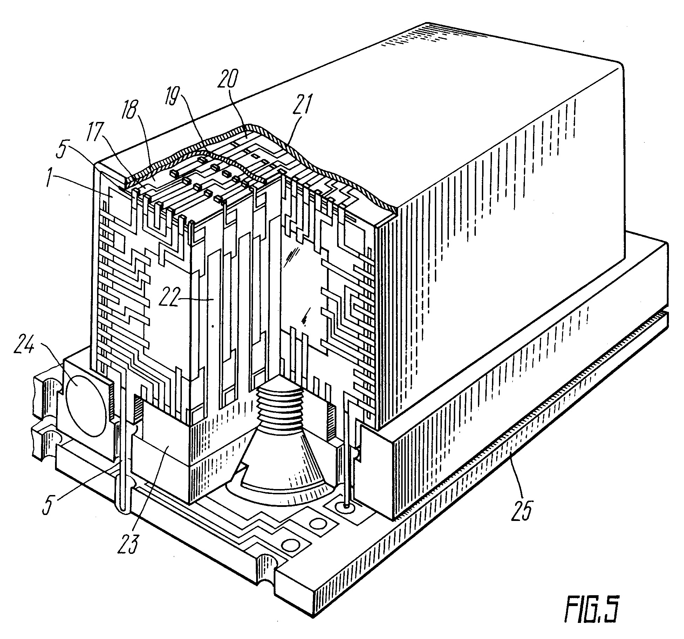

Im Baustein sind die Träger 1 (Fig. 5) parallel zueinander angeordnet. Über die Flächen des Bausteins sind die Träger 1 durch Leiter 17 elektrisch verbunden, die auf eine flexible Leiterplatte 18 aufgebracht sind, wodurch eine wahlfreie Verdrahtung über die Flächen des Bausteins ermöglicht wird.

Um die Zuverlässigkeit zu erhöhen, werden die verlängerten Kontakte 5 der Träger 1 nach vorherigem Überziehen mit einer Hülle 19 aufgeschlossen und auf die Oberfläche des Bausteins Zusatzleiter 20 aufgetragen. Danach wird der Baustein durch Überziehen mit einer polymeren Hülle 21 endgültig hermetisiert. Die Konstruktion des Bausteins sieht eine unmittelbare Einführung von wärmeleitenden Rippen 22 mit einem Wärmeabfuhrelement 23 des Mittels zur Wärmeableitung in die Heizzonen vor. Der Baustein ist mechanisch mit einem gemeinsamen Kühlsystem 24 verbunden, während die Aussenanschlusskontakte 5 der Träger 1 einen Kontakt mit einer gemeinsamen Schaltungsplatte 25 unterhalten, wodurch Aussenanschlüsse des Bausteins gebildet werden.

Die Träger 1 (Fig. 6) können im Baustein miteinander durch Vergiessen mit einem polymeren Material 26, durch Aufschluss der Stirnseiten der Anschlüsse der Träger 1, durch Auftragen von Leitern 20 auf die Oberfläche des Bausteins verbunden werden. Hierbei können die Leiter 20 gegen die Stirnseiten der Anschlüsse des Trägers 1 um einiges verschoben werden. Beim anschliessenden Verzinnen wird die Verbindung zwischen dem Leiter 20 und dem Kontakt 5 des Trägers 1 durch Löten dubliert, wodurch die Sicherheit der Verbindung erhöht wird.

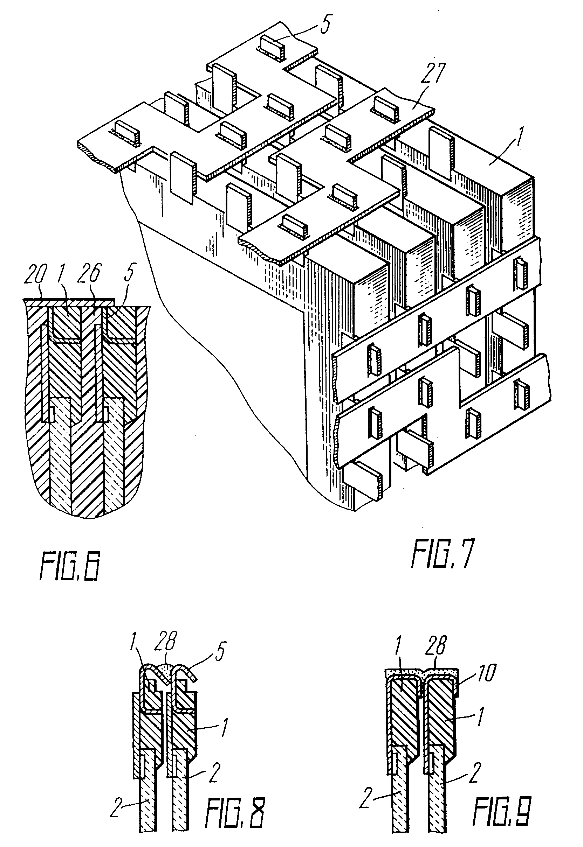

Die Träger 1 (Fig. 7) können im Baustein durch räumliche Leiter 27 verbunden werden. Die räumlichen Leiter 27 vorgegebener Konfiguration sind auf die ausragenden Kontakte 5 der Träger 1 aufgesetzt und mit ihnen elektrisch, beispielsweise durch Löten, verbunden. Im Falle des Austausches des Trägers 1 werden die Abschnitte aus seiner Nähe mechanisch entfernt, der Träger 1 ausgewechselt und der Baustein durch Verlöten von Reserveleitern 27 der gleichen Konfiguration wiederhergestellt.

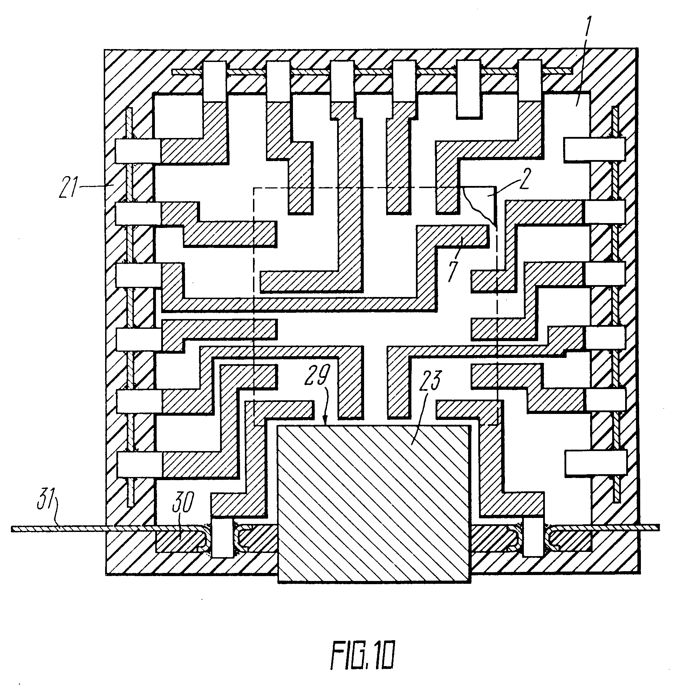

Die Träger 1 (Fig. 8) können im Baustein durch die Anschlusskontakte 5 verbunden werden, die in Form fester Metallbalken ausgeführt sind. Die Kontakte 5 werden vorerst derart abgebogen, dass deren Kontakt mit dem benachbarten Träger 1 bei der Montage des Bausteins gewährleistet ist. Hierbei kann man den Baustein vorprüfen und die ausgefallenen Träger 1 leicht auswechseln, worauf die Träger 1 durch ein Lötmittel 28 umgelötet werden. In der in Fig. 9 dargestellten Ausführungsform des Bausteins liegen die Träger 1 mit den auf die Front-, Stirn- und Rückseite des Trägers 1 aufgetragenen Anschlusskontakten 5 in einem Abstand zueinander. Bei einer gruppenweisen Lötung (beispielsweise einer Schwallötung) dringt ein schmelzflüssiges Lötmittel 28 aufgrund des Kapillareffekts in den Spalt zwischen den Trägern 1 und verbindet die Anschlusskontakte 5 der benachbarten Träger 1 miteinander. Ist ein Austausch des Trägers 1 erforderlich, wird die Zone seiner Berührung mit den benachbarten Trägern 1 auf die Schmelztemperatur des Lötmittels 28 örtlich erhitzt, der Träger 1 wird gegen einen intakten ausgewechselt, und die Lötung wird wiederholt.

Für die Zwecke der Vergrösserung der Pakkungsdichte ist es zweckmässig, die hohe Wärmeleitfähigkeit des Substratmaterials mancher elektronischer Bauelemente zur unmittelbaren Wärmeenergieübertragung auf das Wärmeabfuhrelement 23 (Fig. 10) auszunutzen. In diesem Fall hat der dem Träger 1 angehörende Kristall 2 einen unmittelbaren Wärmekontakt mit dem Wärmeabfuhrelement 23 über zumindest eine Oberfläche 29. Die Besonderheit der genannten Konstruktion besteht darin, dass die Leiter 7 auf eine Isolierschicht aufgetragen sind, die die Frontfläche des Kristalls 2 verdeckt. Die Konstruktion des erwähnten Bausteins sieht das Vorhandensein einer Zwischenschaltungsplatte 30 mit planaren Aussenanschlüssen 31 vor. Der Baustein wird durch eine polymere Hülle 21 hermetisiert.

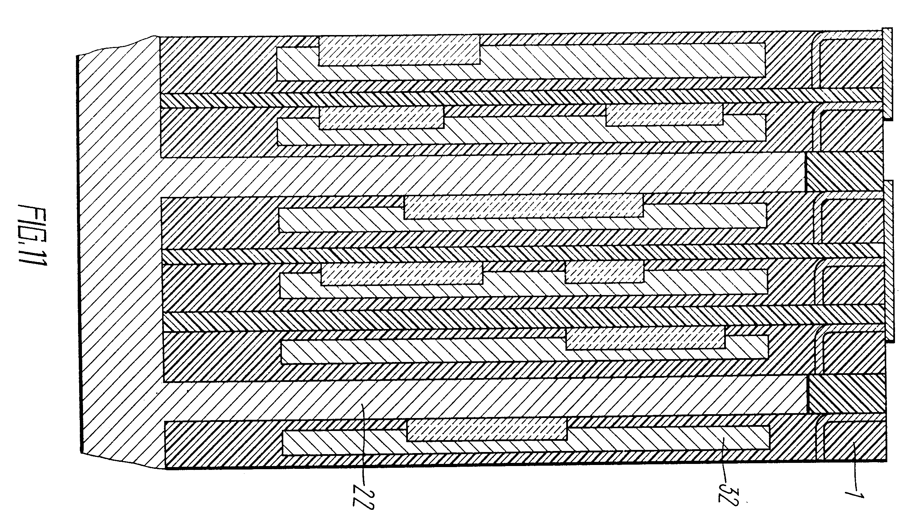

Um die Wärmehaltung bei den elektronischen Bauelementen zu erleichtern und folglich die Zuverlässigkeit der Geräte zu erhöhen, sind die Träger 1 (Fig. 11) mit Platten 32 aus einem Werkstoff mit hoher Wärmeleitfähigkeit versehen. Der Kristall unterhält einen Wärmekontakt mit dieser Platte 32, die als Wärmeabfuhrelement innerhalb des Trägers 1 auftritt. Dies ist bei Benutzung von wärmeentwickelnden elektronischen Bauelementen unterschiedlicher Grösse besonders wirksam. In diesem Fall werden günstige Bedingungen zur Wärmeflussleitung längs des Bausteins unter geringen Verlusten geschaffen. Hierbei können die wärmleitenden Rippen 22 recht undicht angeordnet werden, was die Packungsdichte vergrössert.

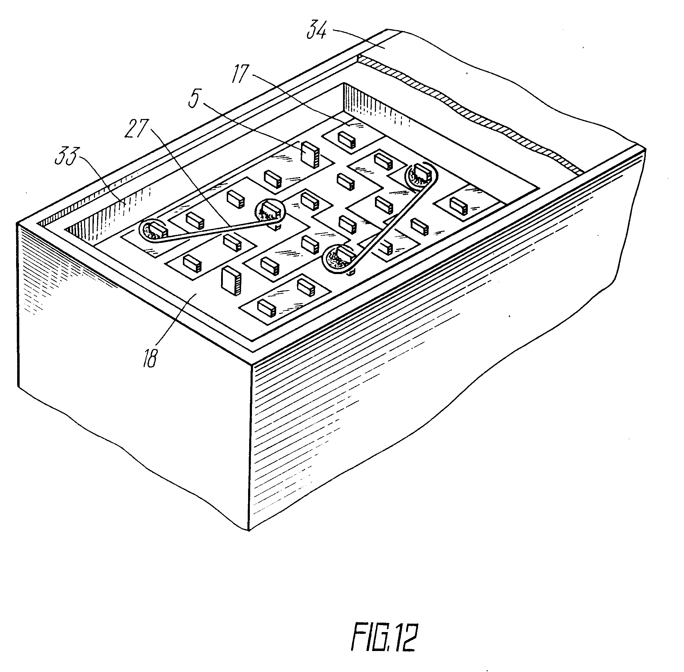

Um eine Reparatur oder eine teilweise Änderung der Verdrahtung zwischen den Trägern 1 (Fig. 12) zu ermöglichen, wird im dicht abgeschlossenen Baustein ein Fenster 33 mit einem offenliegenden Teil der gedruckten Schaltungsplatte 18 ausgeführt. Auf die durch die Platte 18 hindurchgeführten ausragenden Kontakte 5 der Träger 1 werden, falls erforderlich, die räumlichen Leiter 27 oder die gekapselten Bauelemente aufgelötet. Es ist auch eine mechanische Unterbrechung der vorhandenen Leiter 17 möglich. Das Fenster 33 wird durch einen Deckel 34 (Fig. 12) verschlossen.

Als Träger 1 können im Baustein die Gehäuse beliebiger gekapselter Bauelemente mit planaren oder axialen Anschlüssen benutzt werden.

Das erfindungsgemässe Verfahren zur Herstellung eines dreidimensionalen elektronischen Bausteins geschieht wie folgt.

Vor Beginn der Montage werden die elektronischen Bauelemente nach dem Prinzip der Mindestzahl der Aussenverbindungen beim Träger 1 und der Erhaltung der erforderlichen Funktionsfähigkeiten bei einer begrenzten Anzahl von Typenelementen gruppiert. Dies erlaubt es im weiteren, das Montageverfahren leicht zu automatisieren und hohe Betriebseigenschaften beim Erzeugnis zu erzielen.

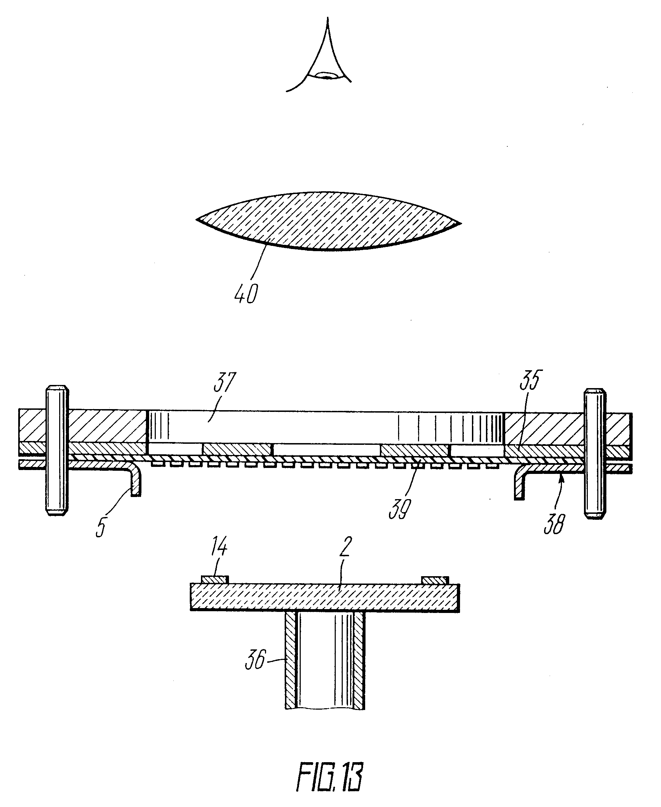

Ist eine genaue Orientierung erforderlich, wird ein Verfahren angewendet, das auf dem Zusammenfallen der Kontaktflächen 14 (Fig. 13) des Bauelements mit einer vorgefertigten Maske bzw. Schablone 35 beruht. Das Bauelement, beispielsweise der Kristall 2, wird mittels einer Ansaugvorrichtung 36 angebracht, an einem Schablonenhalter 37 wird beispielsweise mit Hilfe eines Dauermagneten die Maske bzw. Schablone 35 befestigt, die Öffnungen aufweist. Ferner wird am Schablonenhalter 37 ein Rahmen 38 mit den Anschlusskontakten 5 angeordnet, der vorher an eine auf eine durchsichtige Folie 39 aufgetragene Klebstoffschicht angeklebt ist. Mit Hilfe eines optischen Systems 40 wird durch Verschiebung des Schablonenhalters 37 ein Zusammenfallen der Kontaktflächen 14 mit Stegen der Maske bzw. Schablone 35 herbeigeführt. Dann wird der Kristall 2 mit der Frontseite an die Folie 39 angeklebt und durchwärmt, bis die Klebstoffschicht auf der Folie 39 teilweise polymerisiert. Hiernach werden der an die Folie 39 angeklebte Kristall 2 und der Rahmen 38, gegeneinander ausgerichtet, weiteren Operationen zugeführt.

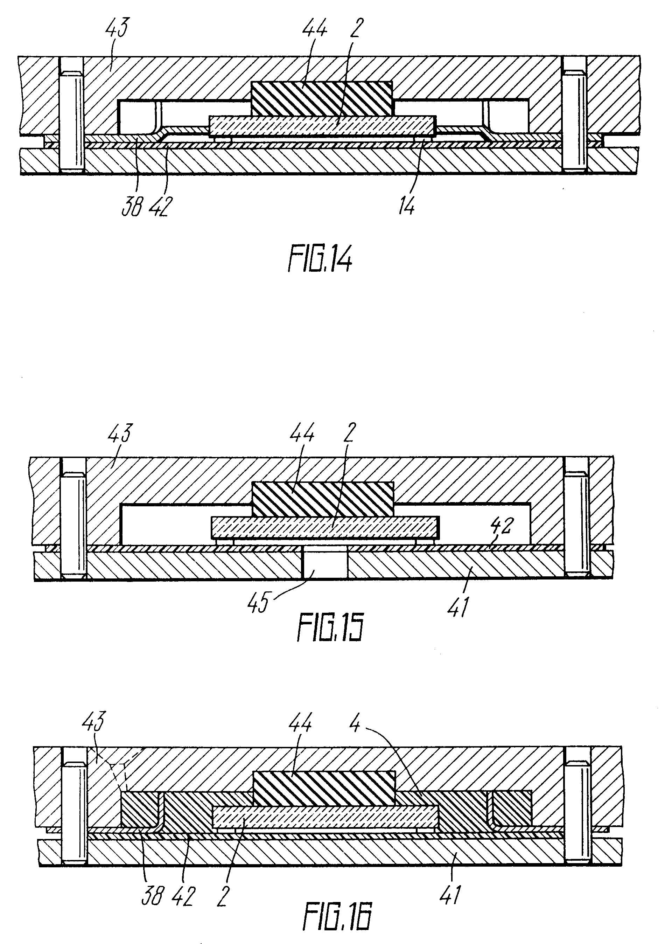

Falls die Kontur des Kristalls 2 (Fig. 14) mit einer genügend hohen Genauigkeit bezüglich der Kontaktflächen 14 ausgeführt ist, kann der Kristall 2 nach seiner Kontur orientiert werden. Der Kristall 2 wird in das Fenster einer Schablone eingesetst, als welche der Rahmen 38 dient. Auf eine Grundplatte 41 wird vorerst ein elasischer Überzug 42 aufgetragen. Im entsprechenden Montageteil 43 wird eine elastische Andrückvorrichtung 44 untergebracht, die den Kristall 2 vorübergehend fixiert.

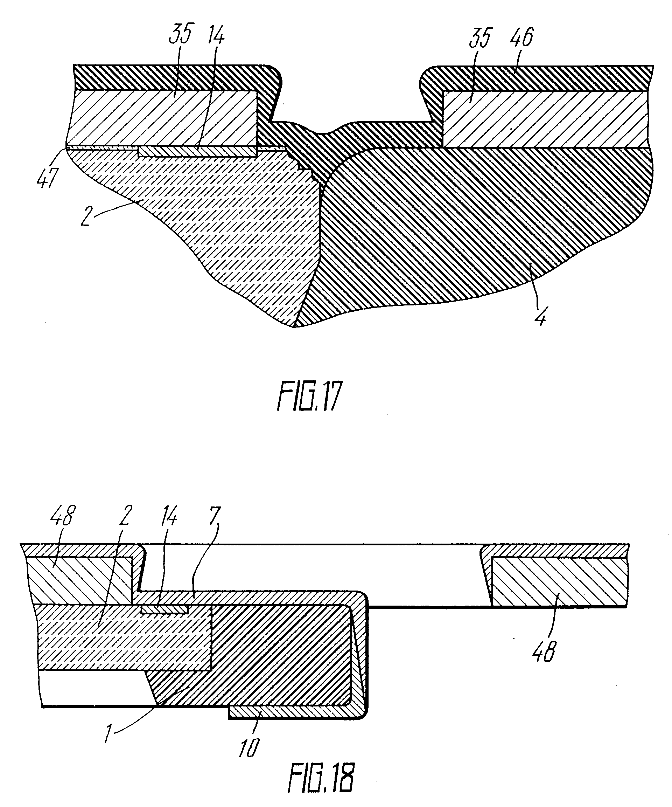

Es ist eine vorläufige Fixierung des Bauelements, beispielsweise des Kristalls 2 (Fig. 15), durch Vakuumansaugung möglich. Der Kristall 2 wird mit Hilfe von Automatisierungsmitteln auf der Grundplatte 41 befestigt. Hierbei wird der Kristall 2 durch ein Vakuum festgehalten, das in der Öffnung 45 der Platte 41 erzeugt wird. Nach der Kupplung mit dem entsprechenden Teil 43 und dem Andrücken des Kristalls 2 durch die elastische Andrückvorrichtung 44 wird das Vakuum abgeschaltet. Die nach Fig. 14 und 15 erhaltene Montageeinheit kann als Pressform zur endgültigen Befestigung der Bauelemente im Träger 1 dienen.

Die endgültige Befestigung des Kristalls 2 (Fig. 16) kann durch das polymere Material 4 vorgenommen werden. Hierbei wird der Kristall 2 durch die elastische Andrückvorrichtung 44 gegen den Überzug 42 angedrückt, wodurch einem Zugiessen des polymeren Materials 4 im Augenblick der Pressung entgegengewirkt wird. Gleichzeitig wird auch der Rahmen 38 umpresst.

Nach der Befestigung durch das polymere Material 4 (Fig. 17) wird eine lokale Auftragung von Poren und Durchgangslöcher eliminierenden Isolationsschichten auf die Frontseite des Trägers 1 vorgenommen, um die stromleitenden Zonen der Bauelemente zu schützen. Auf die Stoßstelle des Kristalls 2 und des polymeren Materials 4 wird beispielsweise durch eine pyrolytische Abscheidung eine Schutzschicht 46 beispielsweise von Siliziumnitrid aufgebracht. Hierbei wird von der gleichen Maske bzw. Schablone 35 wie auch bei der Orientierung des Kristalls 2 (Fig. 13) Gebrauch gemacht. Die Maske bzw. Schablone 35 verdeckt die Kontaktflächen 14 des Kristalls 2, wobei sie die durch eine Passivierungsschicht 47 ungeschützten Zonen des Bauelements offen lässt. Falls die Isolationsschicht 6 (Fig. 1) als Auftragung aus polymerem Material auf den ungeschützten Zonen des Kristalls 2 entsteht, fällt die genannte Operation weg.

Vor der Aufbringung der Leiter 7 werden die Kontaktflächen 14 (Fig. 3) von den organischen Verschmutzungen (beispielsweise plasmachemisch) und von den Oxydschichten (beispielsweise durch Ionenbeschuss) gereinigt. Diese Operation ist zweckmässigerweise im gleichen Vakuumzyklus mit der Auftragung der Leiter 7 (Fig. 1) auf als Block montierten Anlagen durchzuführen. Die Auftragung der Leiter 7 auf die Kontaktflächen 14 (Fig.

18) der Bauelemente und der Oberfläche des Trägers 1 erfolgt in einem beliebigen bekannten Verfahren, beispielsweise durch eine Vakuumaufdampfung von Metallfolien über freie Masken. Es ist eine Variante einer mit der Auftragung der Leiter 7 gleichzeitigen Formierung der Anschlusskontakte 5 des Trägers 1 möglich. Auf den Träger 1 werden nacheinander die Anschlusskontakte 5 beispielsweise durch eine Vakuumaufdampfung über eine "freie" Maske 48 gleichzeitig mit den übrigen auf die Front- und Stirnfläche des Trägers 1 aufzutragenden Leitern 7 aufgebracht.

Der Träger 1 wird vor der Montage einem elektrothermischen Training und einer Funktionsprüfung unterzogen.

Die Verbindung der Träger 1 (Fig. 5,6,7,8,9) zu einem Baustein erfolgt durch Löten, Schweissen, Kleben unter Zuhilfenahme eines leitenden Materials. Falls nötig, lassen sich die auf den Trägern 1 und den Flächen des Bausteins befindlichen Träger 1 durch einen Leiterwerkstoff beispielsweise durch Verzinnung oder galvanische Abscheidung aufwachsen.

Industrielle Anwendbarkeit

Die Erfindung kann mit Erfolg verwendet werden:

- in der Rechentechnik zur Schaffung einer breiten Palette von Digitalgeräten;
- im Gerätebau zur Schaffung von miniaturisierten Digital- und Digital-Analog-Geräten und -Gebern sowie von Sprachsynthetisatoren und -analysatoren;
- in der Medizin zur Schaffung von Geräten zur Diagnosestellung und Behandlung, die der Realisierung von zusammengesetzten Funktionen bei geringer Masse und Grösse bedürfen;
- in der Raumtechnik zur Schaffung von miniaturisierten Forschungsgeräten;
- in der Haushaltstechnik zum Einsatz in kompakten Personalcomputern, Tonbandgeräten, Radioempfängern und anderen Erzeugnissen funktechnischer Bestimmung;
- im Maschinenbau zur Schaffung von Steuersystemen für die Werkstückbearbeitung;
- in der Industrie der Fernmeldeeinrichtungen zur Entwicklung von grundsätzlich neuen Apparaten für die Funkfernsprech-, Funk- und Fernsehverbindung;
- in der Kernenergetik zur Herstellung von Geräten und Gebern, die unter harten Betriebsverhältnissen arbeiten;
- in der Messtechnik mit gesteigerten Forderungen an die Zuverlässigkeit und Kompaktheit;
- in der Fernsehtechnik zum Einsatz in tragbaren Sendeeinrichtungen und in der kosmischen Fernsehverbindungstechnik;
- in speziellen Funkgeräten, die unter beträchtlichen mechanischen Überlastungen und bei Einhaltung von harten Temperaturzyklen arbeiten.

**Patentansprüche**

1. Dreidimensionaler elektronischer Baustein, der elektronische Bauelemente enthält, die in Trägern (1) untergebracht sind, welche am Umfang mit Anschlusskontakten (5) versehen und parallel zueinander in dem Baustein angeordnet sind, der mit Mitteln zur Wärmeableitung und mit Mitteln zur Beschaltung der Träger (1) über die Seitenflächen des Bausteins ausgestattet ist, dadurch **gekennzeichnet**, dass bei Benutzung von gehäuselosen elektronischen Bauelementen im Baustein diese gegeneinander orientiert angeordnet sind und in den stromleitenden Zonen ausser Kontaktflächen (14) auch noch eine Isolierschicht (6) aufweisen, auf der Oberfläche der Träger (1) und der elektronischen Bauelemente Leiter (7) angebracht sind, die die elektronischen Bauelemente untereinander und, oder mit den Anschlusskontakten (5) sowie die Träger (1) im Baustein verbinden, wobei der Baustein auf seiner Oberfläche über Mittel zur festen Verdrahtung der Träger (1) untereinander verfügt, jeder Träger (1) mindestens einen auf die Oberfläche des Bausteins gehenden und als Aussenanschluss dienenden Anschluss besitzt, wobei das Mittel zur Wärmeableitung in Form unmittelbar in den Heizzonen angeordneten wärmeleitenden Rippen (22) und eines Wärmeabfuhrelements (23) ausgeführt ist, wobei der Baustein in einer hermetisierenden Hülle (21) eingeschlossen ist.

2. Dreidimensionaler elektronischer Baustein nach Anspruch 1, dadurch **gekennzeichnet**, dass die Anschlusskontakte (5) der Träger (1) in Form fester Metallbalken hergestellt sind.

3. Dreidimensionaler elektronischer Baustein nach Anspruch 1, dadurch **gekennzeichnet**, dass mindestens ein Träger (1) samt den daran befestigten elektronischen Bauelementen in Form einer monolithischen Konstruktion hergestellt ist, wobei die elektronischen Bauelemente und der aus polymerem Material (4) hergestellte Träger (1) eine einheitliche Frontfläche besitzen.

4. Dreidimensionaler elektronischer Baustein nach Anspruch 3, dadurch **gekennzeichnet**, dass bei den Trägern (1) Nuten (8) und Fenster (9) in Spannungskonzentrationszonen ausgeführt sind, die an den Stirn- und Rückflächen der elektronischen Bauelemente anliegen.

5. Dreidimensionaler elektronischer Baustein nach Anspruch 3, dadurch **gekennzeichnet**, dass die Isolierschicht (6) auf den Trägern (1) in Form einer teilweisen Auftragung auf die Frontseite der elektronischen Bauelemente aus dem polymeren Material (4) des Trägers (1) erzeugt ist.

6. Dreidimensionaler elektronischer Baustein nach Anspruch 3, dadurch **gekennzeichnet**, dass die Isolierschicht (46) auf den Trägern (1) in Form einer dünnen Dielektrikumschicht erzeugt ist, die auf die Oberflächen der elektronischen Bauelemente und der Träger (1) aufgebracht ist.

7. Dreidimensionaler elektronischer Baustein nach Anspruch 1, dadurch **gekennzeichnet**, dass mindestens ein Träger (1) in Form einer am Aussenrahmen (II) des Trägers (1) befestigten flexiblen Leiterplatte (12) mit einer die Aussenanschlusskontakte auf der Front-, Stirn- und Rückfläche des Trägers (1) bildenden Verdrahtung (11) hergestellt ist.

8. Dreidimensionaler elektronischer Baustein nach Anspruch 1, dadurch **gekennzeichnet**, dass mindestens einer der Träger (1) aus Einzelteilen (15) besteht, die elektrisch und mechanisch über auf deren Oberflächen liegende Kontakte (16) verbunden sind.

9. Dreidimensionaler elektronischer Baustein nach Anspruch 3, dadurch **gekennzeichnet**, dass die Träger (1) mit Platten (32) versehen sind, die aus einem Werkstoff mit einer hohen Wärmeleitfähigkeit hergestellt und in denen die elektronischen Bauelemente untergebracht sind.

10. Dreidimensionaler elektronischer Baustein, der elektronische Bauelemente enthält, die in Trägern (1) untergebracht sind, welche am Umfang mit Anschlusskontakten (5) versehen und parallel zueinander in dem Baustein angeordnet sind, der mit Mitteln zur Wärmeableitung und mit Mitteln zur Beschaltung der Träger (1) über die Seitenflächen des Bausteins ausgestattet ist, dadurch **gekennzeichnet**, dass der Baustein mindestens ein in einem als Träger (1) dienenden Gehäuse eingeschlossenes elektronisches Bauelement aufweist, wobei der Baustein auf seiner Oberfläche Mittel zur festen Verdrahtung der Anschlüsse der Träger (1) untereinander besitzt, während jedes gekapselte elektronische Bauelement mindestens einen auf die Oberfläche des Bausteins gehenden und als dessen Aussenanschluss dienenden Anschluss aufweist, wobei das Mittel zur Wärmeableitung in Form von unmittelbar in den Heizzonen angeordneten wärmeleitenden Rippen (22) und eines Wärmeabfuhrelements (23) ausgeführt ist, wobei der Baustein in einer hermetisierenden Hülle (21) eingeschlossen ist.

11. Dreidimensionaler elektronischer Baustein, der elektronische Bauelemente enthält, die in Trägern (1) untergebracht sind, welche am Umfang mit Anschlußkontakten (5) versehen und parallel zueinander in dem Baustein angeordnet sind, der mit Mitteln zur Wärmeableitung und mit Mitteln zur Beschaltung der Träger (1) über die Seitenflächen des Bausteins ausgestattet ist, dadurch **gekennzeichnet**, dass der Baustein gehäuselose elektronische Bauelemente und mindestens ein in einem als Träger (1) dienenden Gehäuse eingeschlossenes elektronisches Bauelement aufweist, wobei die gehäuselosen elektronischen Bauelemente in den Trägern (1) gegeneinander orientiert angeordnet sind und in den stromleitenden Zonen ausser Kontaktflächen (14) auch noch eine Isolierschicht (6) besitzen, wobei auf der Oberfläche der Träger (1) und der gehäuselosen elektronischen Bauelemente Leiter (7) angebracht sind, die die elektronischen Bauelemente untereinander und/oder mit den Anschlusskontakten der Träger (1) sowie die Träger (1) im Baustein verbinden, wobei der Baustein auf seiner Oberfläche über Mittel zur festen Verdrahtung der Träger (1) und der gekapselten elektronischen Bauelemente untereinander verfügt, während jeder Träger (1) und jedes gekapselte elektronische Bauelement mindestens einen auf die Oberfläche des Bausteins gehenden und als dessen Aussenanschluss dienenden Anschluss aufweist, wobei das Mittel zur Wärmeableitung in Form von unmittelbar in den Heizzonen angeordneten wärmeleitenden Rippen (22) und eines Wärmeabfuhrelements (23) ausgeführt ist, wobei der Baustein in einer hermetisierenden Hülle (21) eingeschlossen ist.

12. Dreidimensionaler elektronischer Baustein nach Anspruch 1 oder 10 oder 11, dadurch **gekennzeichnet**, dass das Mittel zur festen Verdrahtung der Träger (1) mindestens eine gedruckte Leiterplatte (I8) enthält, die mit den Anschlusskontakten (5) der Träger (1), welche auf den Stirnflächen der letzteren angebracht sind, und/oder mit den Anschlüssen der gekapselten elektronischen Bauelemente verbunden ist.

13. Dreidimensionaler elektronischer Baustein nach Anspruch 1 oder 10 oder 11, dadurch **gekennzeichnet**, dass das Mittel zur festen Verdrahtung der Träger (1) in Form von Leitern (20) ausgeführt ist, die unmittelbar auf die Oberfläche des Bausteins unter teilweiser Überdeckung der Anschlusskontakte (5) der Träger (1) und/oder der Anschlüsse der gekapselten elektronischen Bauelemente aufgebracht sind.

14. Dreidimensionaler elektronischer Baustein nach Anspruch 2 oder 10 oder 11, dadurch **gekennzeichnet**, dass das Mittel zur festen Verdrahtung der Träger (1) in Form von mindestens einer gedruckten Leiterplatte (18) und von gegeneinander durch eine Isolierschicht (6) getrennten Leitern (20) ausgebildet ist, wobei die Leiter (15) auf der Oberfläche des Bausteins liegen.

15. Dreidimensionaler elektronischer Baustein nach Anspruch 1 oder I0 oder II, dadurch **gekennzeichnet**, dass das Mittel zur festen Verdrahtung der Träger (1) in Form einzelner, über der Oberfläche des Bausteins angeordneter räumlicher Leiter (27) ausgeführt ist.

16. Dreidimensionaler elektronischer Baustein nach Anspruch 1 oder 10 oder 11, dadurch **gekennzeichnet**, dass das elektronische Bauelement wenigstens eine Fläche (29) aufweist, die einen Wärmekontakt mit den Mitteln zur Wärmeableitung hat.

17. Dreidimensionaler elektronischer Baustein nach Anspruch 1 oder 10 oder 11, dadurch **gekennzeichnet**, dass in der hermetisierenden Hülle (21) des Bausteins Fenster (33) zur Ermöglichung einer Korrektur der Verbindungsschaltung der elektronischen Bauelemente ausgeführt sind.

18. Verfahren zur Herstellung eines dreidimensionalen elektronischen Bausteins nach Anspruch 1 oder 11, das die Anordnung der elektronischen Bauelemente im Träger (1), einen elektrischen Anschluss der elektronischen Bauelemente an die Anschlusskontakte (5) des Trägers (1), eine Parallelanordnung der Träger (1) im Baustein, die Beschaltung der Träger (1) über die Seitenflächen des Bausteins umfasst, dadurch **gekennzeichnet**, dass bei Benutzung von gehäuselosen elektronischen Bauelementen im Baustein diese vorher nach dem Prinzip einer mindestmöglichen Anzahl der Anschlusskontakte (5) beim Träger (1) gruppiert, die elektronische Bauelemente gegeneinander ausgerichtet und vorläufig fixiert, die Träger (1) mit einer endgültigen Befestigung der elektronischen Bauelemente in ihnen gefertigt, die ungeschützten stromleitenden Zonen der elektronischen Bauelemente ausser den Kontaktflächen (14) elektrisch isoliert, die Kontaktflächen (14) der elektronischen Bauelemente und die Anschlusskontakte (5) der Träger (1) von organischen Verschmutzungen und Oxydschichten gereinigt auf die Oberflächen der elektronischen Bauelemente und der Träger (1) Leiter (7) aufgebracht, die Anschlusskontakte (5) der Träger (1) auf der Oberfläche des Bausteins elektrisch beschaltet werden, der zusammengebaute Baustein hermetisiert wird.

19. Verfahren zur Herstellung eines dreidimensionalen elektronischen Bausteins nach Anspruchen 1 oder 11, das die Anordnung der elektronischen Bauelemente im Träger (1), einen elektrischen Anschluss der elektronischen Bauelemente an die Anschlusskontakte (5) des Trägers (1), eine Parallelanordnung der Träger (1) im Baustein, die Beschaltung der Träger (1) über die Seitenflächen des Bausteins umfasst, dadurch **gekennzeichnet**, dass bei Benutzung von gehäuselosen elektronischen Bauelementen im Baustein diese vorher nach dem Prinzip einer mindestmöglichen Anzahl der Anschlusskontakte (5) beim Träger (1) gruppiert, die ungeschützten stromleitenden Zonen der elektronischen Bauelemente ausser den Kontaktflächen (14) isoliert, die elektronischen Bauelemente gegeneinander ausgerichtet und vorläufig fixiert, die Träger (1) mit einer endgültigen Befestigung der elektronischen Bauelemente in ihnen gefertigt, die Kontaktflächen (14) der elektronischen Bauelemente und die Anschlusskontakte (5) der Träger (1) von organischen Verschmutzungen und Oxydschichten gereinigt, auf die Oberflächen der elektronischen Bauelemente und der Träger (1) Leiter (7) aufgebracht, die Anschlusskontakte (5) der Träger (1) auf der Oberfläche des Bausteins elektrisch beschaltet werden, der zusammengebaute Baustein hermetisiert wird.

20. Verfahren zur Herstellung eines dreidimensionalen elektronischen Bausteins nach Anspruch 18 oder 19, dadurch **gekennzeichnet**, dass die gehäuselosen elektronischen Bauelemente untereinander nach deren Kontaktflächen (14) in optischen Verfahren ausgerichtet werden.

21. Verfahren zur Herstellung eines dreidimensionalen elektronischen Bausteins nach den Ansprüchen 18 oder 19, dadurch **gekennzeichnet**, dass die gehäuselosen elektronischen Bauelemente untereinander nach ihrer Kontur orientiert werden.

22. Verfahren zur Herstellung eines dreidimensionalen elektronischen Bausteins nach Ansprüchen 18 oder 19, dadurch **gekennzeichnet**, dass die elektronischen Bauelemente vorläufig durch Ankleben mit der Frontseite an einer Klebstoffschicht, die auf einen flexiblen polymeren Film (39) aufgebracht ist, fixiert werden.

23. Verfahren zur Herstellung eines dreidimensionalen elektronischen Bausteins nach Anspruch 18 oder 19, dadurch **gekennzeichnet**, dass auf die Frontfläche der elektronischen Bauelemente eine Klebstoffschicht aufgetragen und die elektronischen Bauelemente vorläufig durch deren Ankleben mit der Frontseite an einem flexiblen polymeren Film (39) fixiert werden.

24. Verfahren zur Herstellung eines dreidimenˋsionalen elektronischen Bausteins nach Anspruch 21, dadurch **gekennzeichnet**, dass die elektronischen Bauelemente durch Anordnung in den Fenstern einer Schablone erst fixiert und dann mit den Kontaktflächen (14) an einen elastischen Überzug (42) angedrückt werden, der auf eine flache Platte (41) aufgebracht ist, bis sie als Bestandteil des Trägers (1) befestigt worden sind.

25. Verfahren zur Herstellung eines dreidimensionalen elektronischen Bausteins nach Anspruch 18 oder 19, dadurch **gekennzeichnet**, dass die elektronischen Bauelemente vorher durch Vakuumandruck der Kontaktflächen (14) an einen elastischen Überzug (42) fixiert werden, der auf eine flache Platte(41) aufgebracht ist, bis sie als Bestandteil des Trägers (1) befestigt worden sind.

26. Verfahren zur Herstellung eines dreidimensionalen elektronischen Bausteins nach Anspruch 22, dadurch **gekennzeichnet**, dass gleichzeitig mit den elektronischen Bauelementen auch ein Metallrahmen (38) als Anschluss durch Ankleben vorläufig fixiert wird.

27. Verfahren zur Herstellung eines dreidimensionalen elektronischen Bausteins nach Anspruch 22 oder 26, dadurch **gekennzeichnet**, dass die Klebstoffschicht nach dem Ankleben der elektronischen Bauelemente und des als Anschluss fungierenden Metallrahmens (38) von den offenen Teilen des flexiblen polymeren Filmes (39) entfernt wird.

28. Verfahren zur Herstellung eines dreidimensionalen elektronischen Bausteins nach Anspruch 18 oder 19, dadurch **gekennzeichnet,** dass die endgültige Befestigung der elektronischen Bauelemente durch ein polymeres Material (4) mit einem an den Werkstoff ihres Substrats angepassten linearen Wärmeausdehnungskoeffizienten vorgenommen wird.

29. Verfahren zur Herstellung eines dreidimensionalen elektronischen Bausteins nach Anspruch 22 oder 23 oder 26, dadurch **gekennzeichnet**, dass der flexible polymere Film (39) nach der endgültigen Befestigung der elektronischen Bauelemente entfernt und die Frontseite der elektronischen Baueelemente und des als Anschluss fungierenden Metallrahmens (38) von der Klebstoffschicht gereinigt wird.

30. Verfahren zur Herstellung eines dreidimensionalen elektronischen Bausteine nach Anspruch 18 oder 19,dadurch **gekennzeichnet**, dass die ungeschützten stromleitenden Zonen der elektronischen Bauelemente durch eine lokale Auftragung von Isolierschichten (46) ohne Poren und Durchgangslöcher isoliert werden.

31. Verfahren zur Herstellung eines dreidimensionalen elektronischen Bausteins nach Anspruch 18 oder 19, dadurch **gekennzeichnet**, dass die Auftragung der Leiter (7) auf die Kontaktflächen (14) der elektronischen Bauelemente und den Träger (1) unter gleichzeitiger Formierung seiner Anschlusskontakte (5) erfolgt.

32. Verfahren zur Herstellung eines dreidimensionalen elektronischen Bausteins nach Anspruch 18 oder 19, dadurch **gekennzeichnet**, dass die Anschlusskontakte (5) der Träger (1) in Form von Balken in der Weise abgebogen werden, dass der elektrische Kontakt zwischen den Anschlüssen der benachbarten Träger (1) unter deren anschliessender Umlötung bei der Montage des Bausteins gesichert wird.

33. Verfahren zur Herstellung eines dreidimensionalen elektronischen Bausteins nach Anspruch 18 oder 19, dadurch **gekennzeichnet**, dass die die Anschlusskontakte (l0) auf der Front- und Rückseite aufweisenden Träger (1) bei deren Anordnung im Baustein mit Abstand angebracht und unter Benutzung eines Kapillareffekts umgelötet werden, wodurch eine mechanische und elektrische Verbindung zustande kommt.

**34.** Verfahren zur Herstellung eines dreidimensionalen elektronischen Bausteine nach Anspruch 18 oder 19, dadurch **gekennzeichnet**, dass nach der Aufbringung der Leiter (7) auf die Träger (1) diese sich durch einen elektrisch leitenden Werkstoff aufwachsen lassen, bis die erforderlichen elektrotechnischen Eigenschaften erreicht worden sind.

FIG.1

FIG.3

FIG.2

FIG.4

FIG.5

FIG.6

FIG.7

FIG.8

FIG.9

FIG.10

FIG.11

FIG.12

40

37    35

5    39    38

14    2

36

FIG. 13

FIG.14

FIG.15

FIG.16

FIG.17

FIG.18

# INTERNATIONAL SEARCH REPORT

International Application No PCT/SU 90/00022

## I. CLASSIFICATION OF SUBJECT MATTER (If several classification symbols apply, indicate all) *

According to International Patent Classification (IPC) or to both National Classification and IPC

Int.Cl.$^5$:    H 01 L 25/04; G 11 C 17/00

## II. FIELDS SEARCHED

### Minimum Documentation Searched 7

| Classification System | Classification Symbols |
|---|---|
| Int.Cl.$^5$: | H 01 L 23/00–23/04, 23/28–23/36 <br> H 01 L 25/00–25/04, 08–16; H 05 K 1/00,02,11,14,18 <br> G 11 C 17/00 |

Documentation Searched other than Minimum Documentation
to the Extent that such Documents are Included in the Fields Searched 8

## III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| A | WO, A1, 83/04141 (HARRIS, JAMES, WILLIAM), 24 November 1983 | 1-33 |
| A | WO, A1, 85/03385 (LATELE-MECANIQUE ELECTRIQUE), 1 August 1985 | 1-17 |
| A | EP, A3, 0065425 (MATSUSHITA ELECTRIC INDUSTRIAL CO, LTD), 24 November 1982 | 1-33 |
| A | EP, A2, 0037301 (THOMSON-CSF), 07 October 1981 | 1-17 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art.

"&" document member of the same patent family

## IV. CERTIFICATION

| Date of the Actual Completion of the International Search | Date of Mailing of this International Search Report |
|---|---|
| 12 December 1990 (12.12.90) | 29 January 1991 (29.01.91) |
| International Searching Authority <br><br> ISA/SU | Signature of Authorized Officer |

Form PCT/ISA/210 (second sheet) (January 1985)